Europäisches Patentamt

European Patent Office

Office européen des brevets

(11) Publication number: **0 020 929**
A1

## EUROPEAN PATENT APPLICATION

(21) Application number: **80102235.1**

(22) Date of filing: **25.04.80**

(51) Int. Cl.³: **H 01 L 29/78,** H 01 L 27/12 // H01L21/86

(30) Priority: **29.06.79 GB 7922697**

(43) Date of publication of application: **07.01.81 Bulletin 81/1**

(84) Designated Contracting States: **DE FR GB**

(71) Applicant: **International Business Machines Corporation, Armonk, N.Y. 10504 (US)**

(72) Inventor: **Fang, Frank, 1691 Cardinal Court, Yorktown Heights New York (US)**
Inventor: **Huntley, Frank Alfred, 6 The Birches Close, North Baddesley Hampshire, S05 9HL (GB)**

(74) Representative: **Blake, John, IBM United Kingdom Patent Operations Hursley Park, Winchester Hants, S021 2JN (GB)**

(54) Improvements relating to field effect transistors.

(57) A field effect transistor of vertical structure includes source (2), channel (3) and drain (4) layers formed successively on an electrically-insulating substrate (1) and etched to form a mesa-like structure. A layer of dielectric material (7) covers at least part of the edge of the channel layer (3) around the periphery of the mesa. The drain electrode (16) is formed over the edge of the channel layer so that an electrically conducting channel can be induced between the source and drain layers at the edge of the channel layer. The transistor structure is particularly suitable for arrays of such transistors adapted for X-Y addressing.

IMPROVEMENTS RELATING TO FIELD EFFECT TRANSISTORS

This invention relates to a field effect transistor which may be formed on an electrically-insulating substrate.

British Patent Specification No 1,517,940 describes an electrochromic display device in which a sheet of transparent conductive material is formed over the inner surface of an electrically-insulating transparent panel to constitute a common electrode for all the display sites of the display device. A plurality of conductive pads is formed on the inner surface of the other panel of the display and each pad is connected to its own transitor switch to enable current to be supplied to any one of the display sites. The aforesaid specification indicates that the transistor switch may be a field effect transistor or a bipolar transistor.

Clearly there are advantages if the transistor can be formed directly on the panel rather than if it has to be formed separately and subsequently mounted on the panel. These advantages include ease and cost of manufacturing as well as packing densities.

Those skilled in the art will appreciate that there are many other applications where it is desirable to form a transistor switch directly on a substrate rather than to mount previously-formed transistors. As an example, liquid crystal displays may require crosspoint switches.

The article "Flat TV Panels with polycrystalline layers" by A G Fischer in Microelectronics, Volume 7, No. 4, pages 5 to 15, describes an array of thin film field effect transistors which are fabricated by vacuum depositing the various
component materials through metal masks.

An object of the present invention is to provide an
improved field effect transistor structure in which the
transistor can be directly formed on an electrically
insulating substrate.  In contrast with the aforementioned
thin film transistors, the field effect transistors of the
present invention have a vertical structure which means that
their channel length is approximately equal to the thickness
of the deposited semiconductor film.

According to the invention, a field effect transistor
comprises an electrically insulating substrate, a mesa on the
substrate containing source and drain layers disposed one
above the other and separated by a channel layer of semiconductor material having an edge extending around the
periphery of the mesa, a layer of dielectric material on said
mesa and covering at least part of said channel layer edge,
and a gate electrode disposed on said dielectric material
over said edge of the channel layer whereby in operation an
electrically conductive channel can be established between
said source and drain layers at said edge.

The invention will now be particularly described, by way
of example, with reference to the accompanying drawings, in
which:

Figure 1 shows initial steps in the formation of one
embodiment of field effect transistor;

Figure 2 shows further steps in the formation of the
transistor;

UK9-78-033E                                    3

Figure 3 shows still further steps in the formation of the transistor;

Figure 4 is a cross-sectional view of the completed transistor structure;

Figure 5 is a plan view showing a possible shape for the transistor;

Figures 6 to 8 show the initial steps of forming an array of field effect transistors;

Figures 9 to 13 illustrate steps in the formation of a further embodiment of transistor;

Figure 14 is a cross-sectional view of a field effect transistor made according to Figures 9 to 13; and

Figure 15 illustrates an alternative construction for the transistor of Figure 14.

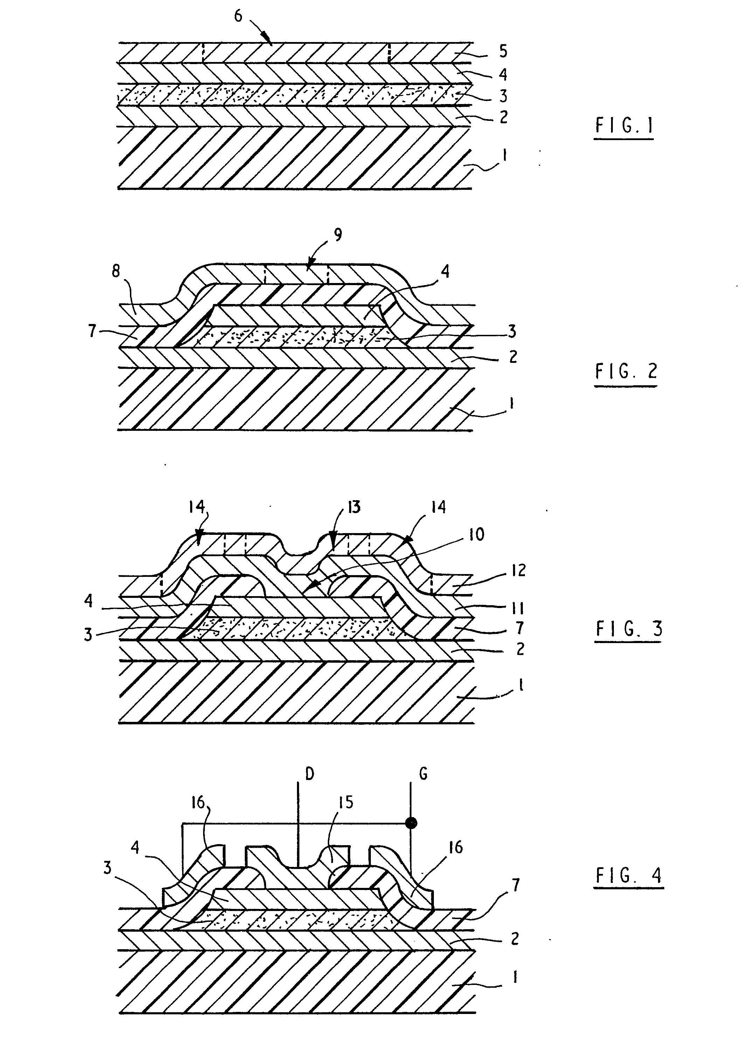

Referring now to Figure 1, an electrically-insulating substrate 1, for example of borosilicate glass, quartz or ceramic material, has successive layers of metal 2, semiconductor material 3 and metal 4. The layer 2 will ultimately form the source of the field effect transistor and can be of any suitable material such as aluminium-chromium alloy or gold. The semiconductor layer 3 which will form the channel region of the transistor can be of any suitable material such as polycrystalline silicon or a group II-IV compound such as CdSe or PbS and will have high resistivity. Typically the layer 3 will be some 5000 A (0.5 microns) thick.  The layer 4, which ultimately will constitute the
region of the transistor, can be of any suitable material,
for example a chromium, aluminium or gold, or a combination
of these.

Any convenient process may be used to form the layers 2,
3 and 4 on the substrate 1 but a prefered technique is to use
a sputter deposition technique since the source material,
semiconductor material and drain material can be deposited
sequentially with a single pump down: as required the substrate can be cleaned between depositions by sputter or
plasma etching.

After the layers 2, 3 and 4 have been formed on the substrate 1, the whole assemply is covered with a layer of
photoresist 5 which is exposed to define a region 6.  After
development of the photoresist layer 5, the layers 3 and 4
are etched to provide a mesa structure as shown in Figure 2.
The mesa structure is next covered with a layer 7 of dielectric material.  Etching can be performed chemically but
again sputter or plasma etching is prefered.  During a single
pump down in the sputter chamber, the drain and channel
layers are etched to form a mesa, the remaining photoresist
is burnt off using an oxygen atmosphere, the mesa structure
is sputter cleaned, and the layer 7 of gate dielectric
material is formed over the mesa structure.   The gate
dielectric material can be constituted, for example by
alumina ($Al_2O_3$) or silica ($SiO_2$).  A layer of
photoresist 8 is formed over the dielectric layer 7 and this
is exposed to define a drain contact region 9.  After
developing the photo resist layer 8, a window 10 is etched in
the dielectric layer 7 to expose the drain region 4, Figure
3.  After removing the remaining photoresist 8, a layer 11 of gate and drain contact metallurgy is deposited over the dielectric layer 7. Any suitable contact material may be used such as aluminium or gold. Next a layer 12 of photoresist is formed over the layer 11 and is exposed, as shown in Figure 3, to define a drain contact region 13 and a gate electrode region 14.

Finally, the photoresist layer 12 is developed and the exposed regions of the layer 11 are etched to give the structure shown in Figure 4. Electrode 15 constitutes the drain electrode of the field effect transistor, and electrode 16 consitutes its gate electrode: the source electrode (not shown) is connected to the source region 2 by any convenient manner.

The vertical FET structure produced has a number of advantages over the conventional horizontal structure mentioned above. Firstly, the length (L) of the channel is defined by the thickness of the semiconductor layer 3. The minimum length of channel possible will therefore be determined by how thin the layer 3 can be formed but present technology would allow a 0.1 micron thick layer to be formed. The maximum channel length would be determined by considerations of the performance of the transistor. As indicated above, the layer 3 will typically be of the order of 5000 Å (0.5 micron) thick. This means that the device will tend to operate as if it were a single-crystal device notwithstanding the fact that the semiconductor material is polycrystalline. This may be thought of as many small single crystal devices in parallel, with a common gate, separated by grain boundaries: bulk-like mobilities are to be expected. A second advantage is that there is no critical alignment of the gate to source and drain gaps.

UK9-78-033E                                        6

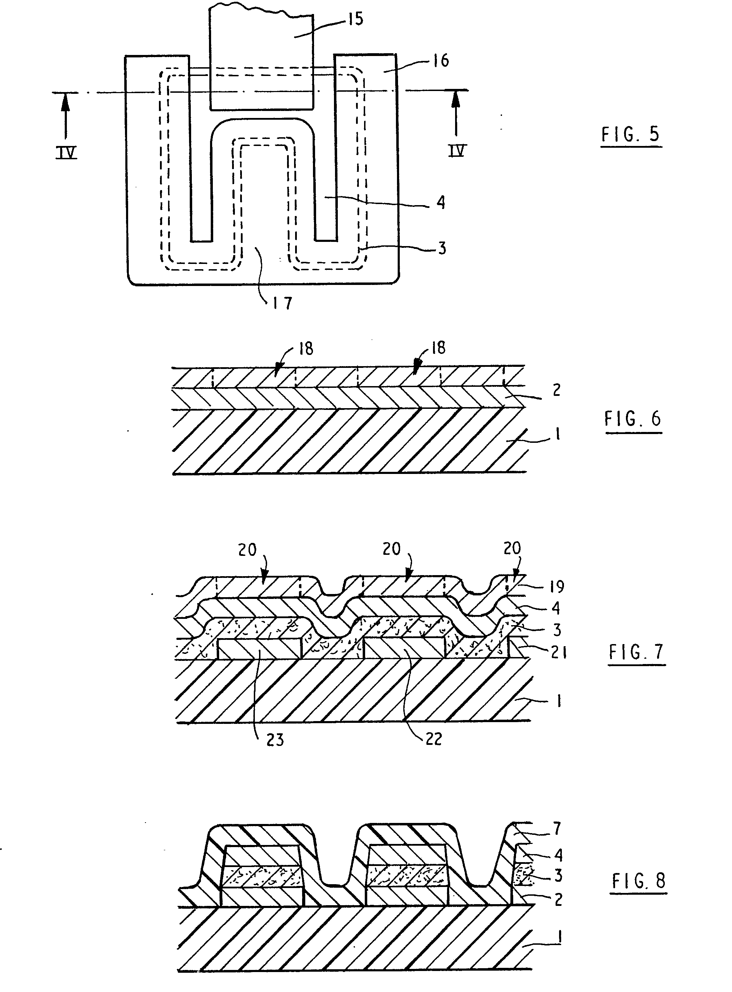

Figure 5 is a simplified plan view of the structure and serves to illustrate a third advantage of the vertical structure.  If the mesa is formed with a re-entrant portion 17, the width (W) of the channel region 3 beneath the gate electrode 16 can be made large compared with the cell size. Thus with a cell size of 10 mils (250 microns) square, it is possible to obtain a value for W of at least 20 mils (500 microns).  This gives a value for the ratio W/L of at least 1000: this is substantially larger than the value of W/L of 50 which would be the maximum possible in a horizontal structure of the same cell size.

Figures 1 to 5 illustrate the structure and formation of a single field effect transistor.  The manufacturing process is readily adaptable to the formation of an array of transistors in which the X-Y addressing conductor cross-overs are incorporated into the transistors themselves to allow a high packing density.

Figures 6 to 8 show the initial steps in forming such an array of transistors.  In Figure 6, a substrate 1 has a layer 2 of source contact region material formed thereon.  A layer of photoresist is formed over the source layer 2 and is exposed to define mesa regions 18.  The photoresist layer is etched in any convenient manner.

As shown in Figure 7, a layer 3 of semiconductor material and a layer 4 of drain region material are formed over the individual source regions 21, 22 and 23 constituted by the etched conductive layer 2.  A layer 19 of photoresist is next deposited over the layer 4 and is exposed to define mesa regions 20.  After development and etching, the resultant mesas are coated with a layer 7 of dielectric material to give the structure shown in Figure 8.  The remaining steps in
the fabrication process are similar to these described above
with reference to Figures 2 to 4.

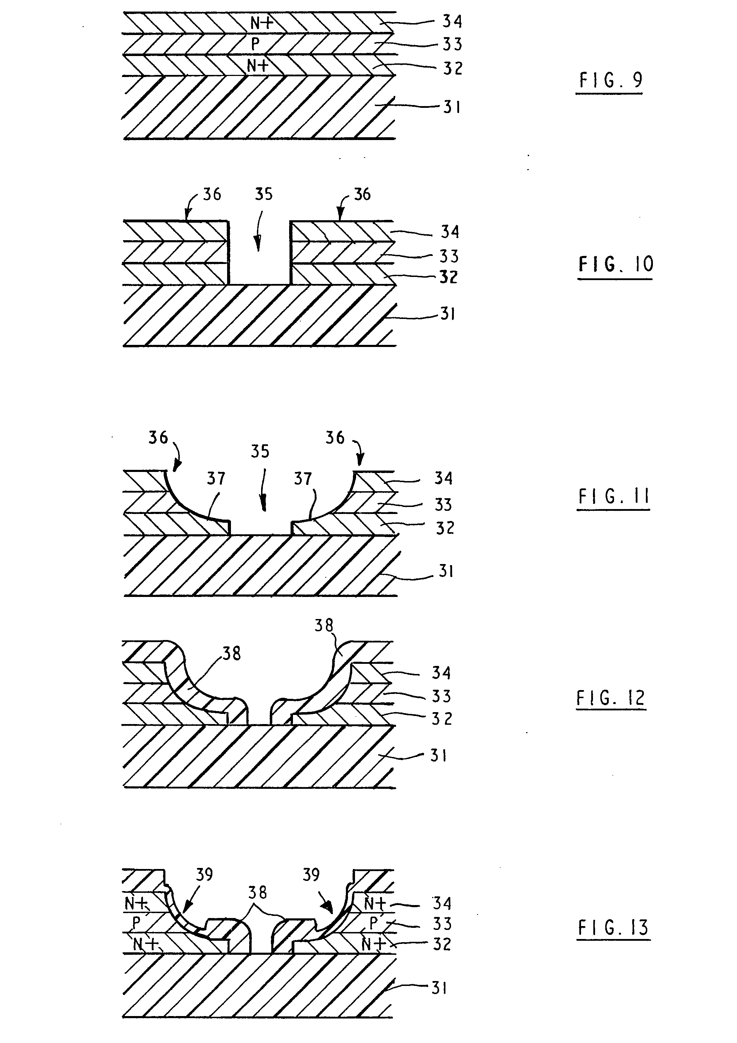

Figures 9 to 13 illustrate the fabrication of a further
embodiment of the vertical field effect transistor
structure.  Referring to Figure 9, a substrate 31 of
refractory electrically-insulating material such as quartz,
alumina or ceramics has deposited thereon three successive
layers of polycrystalline silicon.  The first layer 32 consists of high conductivity N-type of thickness approximately
equal to 3 microns and will eventually constitute the source
region of the transistor.  The second layer 33 consists of
P-type conductivity of thickness approximately equal to 1
micron and will eventually constitute  the channel region of
the transistor.  The third layer 34 consists of high conductivity N-type of thickness approximately equal to 1 micron
and will eventually constitute the drain region of the
transistor.

By using a suitable mask (not shown) and photolithographic techniques, moats 35 are etched in the silicon layers
32 to 34 to leave mesas 36 as shown in Figure 10.  By using a
further mask (not shown) and photolithographic techniques,
the moat 35 is widened to expose areas 37 of the underlying
silicon layer 32 as shown in Figure 11.  During the first
etching process, a unidirectional (anisotropic) etching
technique is employed whilst during the second etching
process, an omnidirectional (isotropic) etching technique is
used.  Those skilled in the art will appreciate that
different chemical etches can be selected to give these
required properties or, if sputter etching is employed,
various parameters such as pressure, frequency of the R.F.

source, etc. can be varied as is known to produce the desired
directional effect.

After broadening of the moats to expose the underlying
silicon layer 32, a thick layer 38 of oxide, approximately
0.8 microns (8000 Å) is thermally grown over the assembly
as shown in Figure 12. Using a mask (not shown) and photolithographic techniques, windows are etched through the thick
oxide layer 38 to expose the edge of the channel region 33: a
thin layer of oxide is then regrown over the exposed areas 39
as shown in Figure 13.

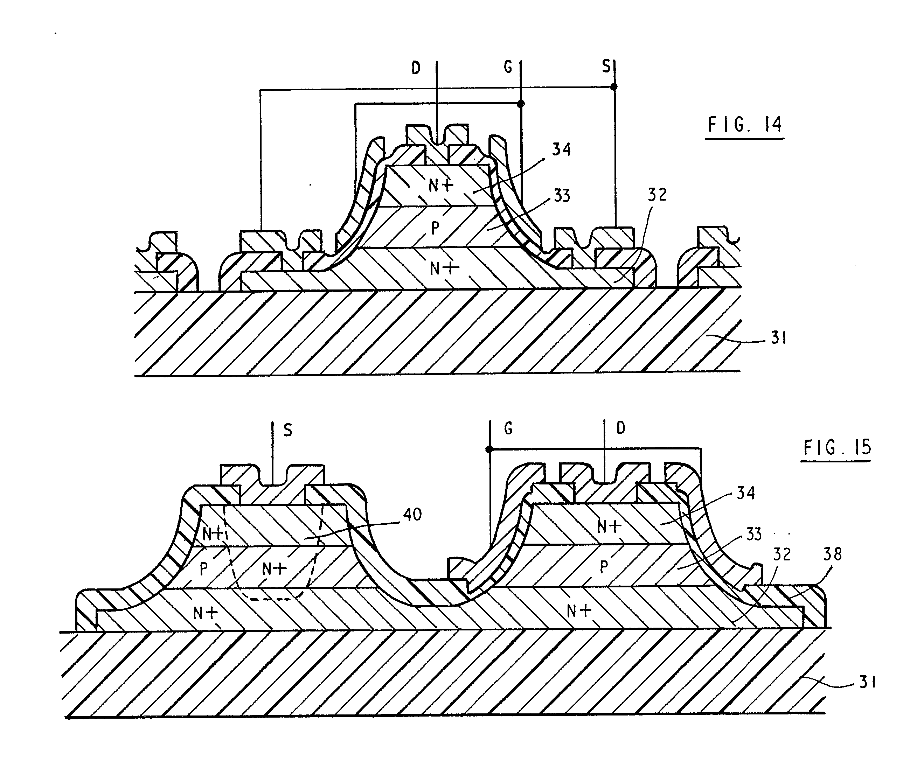

Contact holes for the source and drain regions are next
etched in the oxide layer using conventional photolithographic techniques and finally the contact metallurgy, for
example of aluminium or gold, is formed over the oxide layer
using suitable deposition, photolithographic and etching
techniques. Figure 14 illustrates the completed field effect
transistor. As an alternative, not shown, to using the
highly conductive N-type polycrystalline silicon layers 32
and 34, silicide layers may be used, for example tungsten
silicide. Tungsten silicide could also be used for the
interconnection lines. Advantages of using tungsten silicide
for these purposes are that the silicides have higher
conductivty than highly-doped polycrystalline silicon and the
chemical differentiation of polycrystalline silicon and
tungsten silicide allows the use of self-limiting etches in
fabrication. The advantage of a native oxide dielectric
layers is maintained.

Figure 15 illustrates a modification of the transistor
structure shown in Figure 14 in which an additional mesa has
been formed in each transistor. The source contact is made through a highly dope N-conductivity region 40 extending
through the P-conductivity type layer 33 of the additional
mesa.  The region 40 can be formed by diffusion techniques or
by ion implantation.

UK9-78-033E                                    1

CLAIMS

1.  A field effect transistor comprising source and drain
regions separated by a channel and a gate electrode
characterized in that a mesa formed on an electrically
insulating substrate contains source and drain layers
disposed one above the other and separated by a channel layer
of semiconductor material having an edge extending around the
periphery of the mesa, in that a layer of dielectric material
is formed on said mesa covering at least part of said channel
layer edge, and in that said gate electrode is disposed on
said dielectric material over said edge of the channel layer
whereby in operation an electrically conductive channel can
be established between said source and drain layers at said
edge.

2.  A transistor as claimed in claim 1, characterized in that
said source and drain layers are of gold, chromium and/or
aluminium, or tungsten silicide.

3.  A transistor as claimed in either preceding claim,
characterized in that said channel layer is polycrystalline
silicon, lead sulphide, or cadmium selenide.

4.  A transistor as claimed in any preceding claim,
characterized in that said dielectric material is alumina or
silica.

5.  A transistor as claimed in any preceding claim,
characterized in that said semiconductor layer has a
thickness of the order of 0.5 micron.

UK9-78-033E                          2

6.  A transistor as claimed in claim 1, characterized in that said source and drain layers are of high conductivity silicon of one conductivity type, in that said channel layer is of silicon of the opposite conductivity type, and said dielectric material is thermally grown silicon oxide.

7.  A transistor as claimed in claim 5, characterized in that it comprises a second mesa separated from the first mesa by a moat extending through the drain and channel layers, and in that a high conductivity region of said one type extends through said channel layer within said second mesa to enable electrical connection to be made to said source layer.

8.  A transistor as claimed in any preceding claim, characterized in that said dielectric layer extends generally over the whole surface of said mesa and has a reduced thickness beneath said gate electrode.

FIG. 1

FIG. 2

FIG. 3

FIG. 4

FIG. 5

FIG. 6

FIG. 7

FIG. 8

0020929

N+    34
P    33
N+    32
   31

FIG. 9

36   35   36
34
33
32
31

FIG. 10

36   35   36
37   37
34
33
32
31

FIG. 11

38   38
34
33
32
31

FIG. 12

39   39
38
N+   N+   34
P   P   33
N+   N+   32
31

FIG. 13

FIG. 14

D    G    S

34

33

32

N+

P

N+

31

FIG. 15

S

G    D

40

34

N+

33

P

N+

32

38

N+

P

N+

31

European Patent Office

**EUROPEAN SEARCH REPORT**

| DOCUMENTS CONSIDERED TO BE RELEVANT | | | CLASSIFICATION OF THE APPLICATION (Int. Cl.3) |
|---|---|---|---|
| Category | Citation of document with indication, where appropriate, of relevant passages | Relevant to claim | |
| X | US - A - 3 384 792 (ELECTRO-OPTICAL SYSTEMS)<br><br>* Column 5, lines 23-51; figure 6 *<br><br>-- | 1-4 | H 01 L 29/78<br>27/12//<br>21/86 |
| E,P | DE - A - 2 820 331 (E. LUDER)<br><br>* Claim 3; page 5, paragraph 1; figure 3 *<br><br>-- | 1-4 | |
| A | FR - A - 2 390 004 (COMMISARIAT A L'ENERGIE ATOMIQUE)<br><br>* Claims 1,7; page 7, lines 11-13 *<br><br>-- | | TECHNICAL FIELDS SEARCHED (Int. Cl.3)<br><br>H 01 L 29/78<br>27/12<br>21/84<br>21/86 |
| | US - A - 3 893 155 (HITACHI)<br><br>* Column 3, lines 20-37; figure 2 *<br><br>-- | 1,4,6 | |
| A | THIN SOLID FILMS, vol. 36, no. 2, 2nd August 1976, pages 299-312 Lausanne, CH.<br>J.C. ANDERSON: "Thin film transistors"<br><br>* Page 307, paragraph 4 "CdSe Transistors" *<br><br>-- | 2-4 | |
| A | TECHNICAL DIGEST 1974 INTERNATIONAL ELECTRON DEVICES MEETING, 9th-11th December 1974, pages 573-575<br>IEEE New-York 1974<br><br>./. | 3,4 | CATEGORY OF CITED DOCUMENTS<br><br>X: particularly relevant<br>A: technological background<br>O: non-written disclosure<br>P: intermediate document<br>T: theory or principle underlying the invention<br>E: conflicting application<br>D: document cited in the application<br>L: citation for other reasons<br><br>&: member of the same patent family, corresponding document |

The present search report has been drawn up for all claims

| Place of search | Date of completion of the search | Examiner |
|---|---|---|
| The Hague | 02-10-1980 | VANCRAEYNEST |

EPO Form 1503.1 06.78

| DOCUMENTS CONSIDERED TO BE RELEVANT | | | CLASSIFICATION OF THE APPLICATION (Int. Cl. 3) |
|---|---|---|---|
| Category | Citation of document with indication, where appropriate, of relevant passages | Relevant to claim | |
| | G. KRAMER: "Improved Stability in PbS/Al$_2$O$_3$ Thin-Film Transistors" <br> * Page 573, column 1, paragraphs 3-5 * <br><br> -- | | |
| A | US - A - 3 986 196 (VARIAN ASSOCI-ATES) <br> * Claims 1-3,6 * <br><br> ---- | 7 | |
| | | | TECHNICAL FIELDS SEARCHED (Int. Cl. 3) |

EPO Form 1503.2   06.78